# EUROPEAN PATENT APPLICATION

(11) **EP 4 513 550 A2**
(43) Date of publication of application: **26.02.2025**
(21) Application number: 24195622.6
(22) Date of filing: 21.08.2024
(51) Int. Cl.: H01L 23/473, H01L 23/367, H05K 7/20

(54) **HEAT EXCHANGER WITH CONTACT SEALING AND RELATED SYSTEMS**

(30) Priority: 21.08.2023 US 202363533847 P; 20.08.2024 US 202418810176
(71) Applicant: COOLIT SYSTEMS, INC., Calgary, Alberta T1Y 7H9 (CA)
(72) Inventor: Zakib, Bradley, Calgary, T1Y 7H9 (CA); Messinger, Troy, Calgary, T1Y 7H9 (CA); Kamaleddin Mostafavi Yazdi, Seyed, Calgary, T1Y 7H9 (CA); Serwin, Marek, Calgary, T1Y 7H9 (CA); Reza Najjari, Mohammad, Calgary, T1Y 7H9 (CA); Samie, Milad, Calgary, T1Y 7H9 (CA); Lyal, Nav, Calgary, T1Y 7H9 (CA)
(74) Representative: Cameron Intellectual Property Ltd

(57) **Abstract**

A heat exchanger conveys heat from a heat-generating component to a coolant. The heat exchanger includes a heat spreader plate defining an upper surface. A plurality of fins extend transversely from the upper surface to respective distal fin edges. The plurality of fins define a corresponding plurality of microchannels. A housing defines an underside surface positioned overtop the distal fin edges. The underside surface urges against the distal fin edges sufficiently to substantially inhibit a coolant from leaking from one microchannel to an adjacent microchannel. The fins can be sufficiently compressed between the heat spreader plate and the underside of the housing as to deflect the fins from an unloaded, at-rest orientation. The distal edges of the fins can be flared laterally outward. Such flared distal fin edges can be fused with the underside of the housing and the microchannels can be substantially free of any fusing material.

## Description

### BACKGROUND

The innovations and related subject matter disclosed herein (collectively referred to as the "disclosure") generally pertain to fluid heat-transfer systems and more particularly, but not exclusively, to liquid-cooled cold plates. Some disclosed principles are described in relation to electronics cooling applications by way of example, though the disclosed innovations may be used in a variety of other applications, including in heating applications.

New generations of electronic components, such as, for example, memory components, microprocessors, graphics processors, and power electronics semiconductor devices, produce increasing amounts of heat during their operation. If the heat is not removed at a sufficient rate, the components can overheat, decreasing performance, reliability, or both, and in some cases component damage or failure.

Electronic devices, such as, for example, servers, computers, game consoles, power electronics, communications and other networking devices, batteries, and so on, can use air cooling, liquid cooling (e.g., involving one- or two-phases with say, water or refrigerant, respectively), or both, to transfer and dissipate heat from electronic components to an ultimate heat sink, e.g., the atmosphere. Conventional air cooling relies on natural convection or uses forced convection (e.g., a fan mounted near a heat producing component) to replace heated air with cooler ambient air around the component. Such air-cooling techniques can be supplemented with a conventional "heat sink," which often is a plate of a thermally conductive material (e.g., aluminum or copper) placed in thermal contact with the heat-producing component. The heat sink can spread heat from the component to a larger area for dissipating heat to the surrounding air. Some heat sinks include "fins" to further increase the surface area available for heat transfer and thereby to improve the transfer of heat to the air. Some heat sinks include a fan to force air among the fins and are commonly referred to in the art as "active" heat sinks.

### SUMMARY

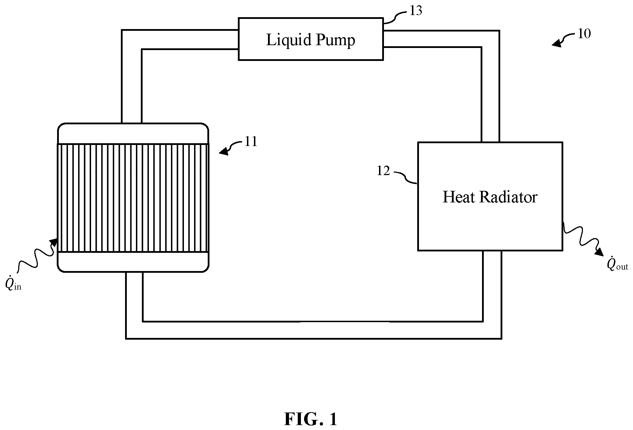

Liquid cooling improves cooling performance compared to air cooling techniques described above, as many liquids, e.g., water, have significantly better heat transfer capabilities than air. FIG. 1 illustrates various components of a liquid cooling loop 10. The cooling loop 10 typically operates by (1) transferring heat, *Q̇*ᵢₙ, from a heat-generating electronic component (not shown) to a cool liquid passing through a heat exchanger 11 (sometimes referred to in the art as a "cold plate" or a "heat sink") placed in thermal contact with the heat-generating component, (2) transporting the heat absorbed by the liquid to a remote radiator 12, or heat rejector (sometimes referred to in the art generally as a "heat exchanger," or a "liquid-to-liquid heat exchanger" if the heat is rejected to another liquid or a "liquid-to-air heat exchanger" if the heat is rejected to air), (3) dissipating the heat, *Q̇*ₒᵤₜ, from the remote radiator to another medium (e.g., air or facility water passing through the remote radiator), and (4) returning cooled liquid to the heat exchanger (or heat sink).

Presently disclosed principles can provide heat exchangers (and related systems and methods) that eliminate conventional features or components (e.g., plates, seals, gaskets, screws or other fasteners) that occupy volume, thereby provide one or more advantages compared to prior heat exchangers. For example, eliminating conventional features or components can increase volume within the heat exchanger that is available to be occupied by heat-transfer features, e.g., by more fins, larger fins, or both, improving a measure of heat-transfer performance within a same-size heat exchanger compared to prior heat exchangers. Alternatively or additionally, eliminating conventional features or components permit the overall heat-exchanger volume to shrink or decrease while maintaining a measure of heat-transfer performance compared to prior heat exchangers.

According to a first aspect, a heat exchanger is configured to convey energy in the form of heat from a heat-generating component to a coolant. The heat exchanger includes a heat spreader plate defining an upper surface and a plurality of fins that extend transversely from the upper surface to respective distal fin edges. The plurality of fins define a corresponding plurality of microchannels between adjacent ones of the plurality of fins. The heat exchanger includes a housing that defines an underside surface positioned overtop the distal fin edges. The underside surface urges against the distal fin edges sufficiently to substantially inhibit a coolant from leaking from one microchannel to an adjacent microchannel.

The heat exchanger can define an inlet passage and an outlet passage. The heat exchanger can be configured to convey the coolant from the inlet passage to the plurality of microchannels and from the plurality of microchannels to the outlet passage.

In some heat exchanger embodiments, the housing and the heat spreader plate are joined together with a high-temperature process.

The plurality of fins extend obliquely from the upper surface of the heat spreader plate in some embodiments.

In some embodiments, the underside surface urges against the distal fin edges sufficiently to deflect the fins from an unloaded, at-rest orientation.

The underside surface can be fused with the distal fin edges.

In some embodiments, the distal fin edges are flared distal fin edges. The underside surface can be fused with the flared distal fin edges. For example, the underside surface can be brazed with the flared distal fin edges.

According to another aspect, a heat exchanger is configured to convey energy in the form of heat from a heat-generating component to a coolant. The heat exchanger includes a heat spreader plate defining an upper surface and a plurality of fins extending transversely from the upper surface to respective distal fin edges. The plurality of fins define a corresponding plurality of microchannels between adjacent ones of the plurality of fins. According to the second aspect, the distal fin edges are laterally flared to at least partially enclose a distal region of each microchannel. The heat exchanger also includes a housing defining an underside surface positioned overtop the flared distal fin edges. The underside surface and the distal fin edges are sufficiently joined together to substantially inhibit a coolant from leaking from one microchannel to an adjacent microchannel.

The heat exchanger can include an inlet passage and an outlet passage. The heat exchanger can be configured to convey the coolant from the inlet passage to the plurality of microchannels and from the plurality of microchannels to the outlet passage.

The housing and the heat spreader plate can be joined together using a high-temperature process.

Each in the plurality of fins can extend obliquely from the upper surface of the heat spreader plate.

The underside surface can urge against the flared distal fin edges sufficiently to deflect the fins from an unloaded, at-rest orientation.

The underside surface can be fused with the flared distal fin edges. For example, the underside surface can be brazed with the flared distal fin edges. The microchannels can be substantially free of any flux or solder or other brazing material.

According to yet another aspect, electronic device are disclosed. Such an electronic device includes a heat-generating electronic component and a cold plate. The cold plate has a heat spreader plate positioned in thermal contact with the heat-generating component and a housing enclosing an interior region of the cold plate. The heat spreader plate defines an upper surface and a plurality of fins extend transversely from the upper surface to respective distal fin edges. The plurality of fins define a corresponding plurality of microchannels between adjacent ones of the plurality of fins. The cold plate also has a housing that defines an underside surface positioned overtop the distal fin edges. The underside surface and the distal fin edges urge together and substantially inhibit a coolant from leaking from one microchannel to an adjacent microchannel. rhe housing and the heat spreader plate are fused together.

In some embodiments, the distal fin edges are laterally flared and the underside of the housing and the flared distal fin edges are also brazed together. In such embodiments, the microchannels can be substantially free of any brazing material.

In some embodiments, the distal fin edges urge in compression between the underside of the housing and the upper surface of the heat spreader plate sufficiently to deflect the plurality of fins from an unloaded, at-rest orientation. The foregoing and other features and advantages will become more apparent from the following detailed description, which proceeds with reference to the accompanying drawings.

### BRIEF DESCRIPTION OF THE DRAWINGS

Referring to the drawings, wherein like numerals refer to like parts throughout the several views and this specification, aspects of presently disclosed principles are illustrated by way of example, and not by way of limitation.
FIG. 1 illustrates a closed liquid-cooling loop.
FIG. 2 shows a top plan view of a fluid heat exchanger having a top cap cut away to facilitate viewing internal components.
FIG. 3 shows a sectional view along line I-I of FIG. 2.
FIG. 4 shows a sectional view along line II-II of FIG. 2.
FIG. 5 schematically illustrates, across typical fin- and channel-dimensions, a relative loss of thermal performance for a cold plate with a fin-top gap that permits coolant to leak from the microchannels compared to thermal performance of a cold plate without a fin-top gap that prevents coolant from leaking out from the microchannels.
FIG. 6 shows a working embodiment of a passive, liquid-cooled cold plate that has been sectioned as along line I-I of FIG. 2.
FIG. 7 shows a heat-spreader plate and a plurality of fins formed thereon from above.
FIG. 8 shows a housing from below, as well as a boss defining a major surface that contacts the fins shown in FIG. 7 when the housing and the heat-spreader plate are joined together as in FIG. 6.
FIG. 9 shows an enlargement of the boxed region in FIG. 6.
FIG. 10 shows a heat-spreader plate and housing placed together in compression within a jig.
FIG. 11 shows a close-up view of the fins of the heat-spreader plate contacting the boss of the housing when the jig shown in FIG. 10 urges the heat-spreader plate and the housing toward each other.
FIG. 12 shows a close-up view as in FIG. 11, except that the jig urges the heat-spreader plate and the housing toward each other with a higher force than the jig applies in FIG. 12, resulting in a greater degree of fin deflection in FIG. 12 than in FIG. 11.
FIG. 13A is a photograph of a portion of an array of fins having flared distal edges.
FIG. 13B schematically depicts a plurality of fins that extend from a heat spreader plate and have flared distal edges.
FIG. 14 is a photograph of an array of fins having a first region with flared distal edges and a second region with raw distal edges.
FIG. 15 shows part of photograph of a cross-sectioned, working embodiment of a cold plate having flared distal edges fused with a housing. The microchannels are substantially devoid of any flux, solder or other brazing material.
FIG. 16 shows an enlarged region of FIG. 15 with a visible bondline between the flared distal edges of the fins and the underside of the housing.

### DETAILED DESCRIPTION

The following describes various principles related to heat exchangers having an interfacial region between two components sealed by urging the two components together, together with principles related to associated methods and systems. For convenience and succinctness, such principles are described by way of reference to exemplary embodiments. That said, descriptions herein of specific apparatus configurations and combinations of method acts are but particular examples of contemplated systems chosen as being convenient, illustrative examples of disclosed principles. One or more of the disclosed principles can be incorporated in various other systems to achieve any of a variety of corresponding system characteristics.

Thus, systems having attributes that are different from those specific examples discussed herein can embody one or more presently disclosed principles and can be used in applications not described herein in detail. Accordingly, such alternative embodiments also fall within the scope of this disclosure.

As noted above, FIG. 1 schematically illustrates a closed liquid-cooling loop 10. The liquid-cooling loop 10 includes a heat exchanger 11 that removes heat, *Q̇ᵢₙ*, from a component (not shown) that generates heat while operating. However, the heat exchanger 11 need not be limited to cooling a single electronic component that dissipates heat while operating. For example, some electronic devices, e.g., servers (alone or installed in a rack, which itself may be installed in a data center), desktop computers, power electronics devices, etc., include a multi-chip module. And, some electronic devices include more than one such multi-chip module. Further, some multi-chip modules require rates of cooling beyond that which air cooling alone can achieve within some electronic devices. Accordingly, some electronic devices require augmented cooling for some or all components mounted to, for example, a multi-chip module.

Accordingly, the heat exchanger 11 shown in FIG. 1 can be configured to cool the heat-dissipating components of one or more multi-chip modules. For example, the heat exchanger 11 can conductively receive heat from the components and transfer it to a liquid coolant passing through the heat exchanger. As described above in connection with FIG. 1, the liquid coolant can flow from the heat exchanger 11 to a heat radiator 12, carrying the received heat to the radiator. As the heated coolant flows through the heat radiator, heat, *Q̇ₒᵤₜ,* can be transferred to another cooling medium, cooling the liquid coolant. The cooled liquid coolant can again pass through the heat exchanger 11 to remove further heat dissipated by the heat-dissipating components of the one or more multi-chip modules (and/or other components). Additionally, one or more pumps 13 can urge the liquid coolant throughout the components of the cooling loop 10.

For instance, the closed liquid-cooling loop 10 may be designed to cool a single processor of a single computer system. In this embodiment, the cooling loop can include but one heat exchanger 11. In another embodiment, the cooling loop can include more than one heat exchanger (only one is shown in FIG. 1), either coupled in series or in parallel with the heat exchanger 11 shown in FIG. 1. In another embodiment, a cooling loop 10 can be installed in a rack of servers (or more than one rack of servers). In such other embodiment, the cooling loop can include a plurality of heat exchangers 11 (fluidically coupled with each other in series or in parallel, e.g., in a group having a plurality of heat exchangers 11 in series with each other, or in a plurality of groups, where heat exchangers in a given group are coupled with each other in series or in parallel with each other and where the plurality of groups are fluidically coupled with each other in series, in parallel, or both. U.S. Patent No. 9,496,200 (hereby incorporated by reference in its entirety for all purposes) describes cooling loops having a plurality of branches, with each branch having one or more heat exchangers 11, some of which may include a housing that integrates the pump 13, conduits or fluid passages, and a cold plate. U.S. Patent No. 9,453,691 (hereby incorporated by reference in its entirety for all purposes) describes embodiments of such integrated pumps and cold plates, sometimes referred to in the art as an "active heat sink" or an "active cold plate." As noted, some heat exchangers do not include a pump and thus are sometimes referred to in the art as "passive" heat exchangers or cold plates. As an example, a heat exchange assembly that incorporates an integrated pump may be substituted for a component heat exchange module that has an integrated pump as described in the '200 patent and the '691 patent. U.S. Patent 8,746,330 (hereby incorporated by reference in its entirety for all purposes) describes a fluid heat exchanger that does not include a pump, e.g., a passive heat exchanger.

As used herein, "fluidic" means of or pertaining to a fluid (e.g., a gas, a liquid, a mixture of a liquid phase and a gas phase, etc.). Thus, two regions that are "fluidically coupled" are so coupled to each other as to permit a fluid to flow from one of the regions to the other region in response to a pressure gradient between the regions.

As used herein, the terms "working fluid" and "coolant" are interchangeable. Although many formulations of working fluids are possible, common formulations include distilled water, ethylene glycol, propylene glycol, and mixtures thereof.

As used herein, the terms "heat sink" and "cold plate" are interchangeable and mean a device configured to transfer energy to a fluid from a device that generates heat (or from a fluid to a device that absorbs heat) through convection (i.e., a combination of conduction and advection) heat transfer. Disclosed heat sinks and cold plates include devices that facilitate a change in phase of a working fluid, as to allow the working fluid to absorb or to reject heat as the working fluid changes phase from liquid to gas, or vice-versa, (e.g., to take advantage of a latent heat of phase change), as well as to superheat a gas phase or to supercool a liquid phase.

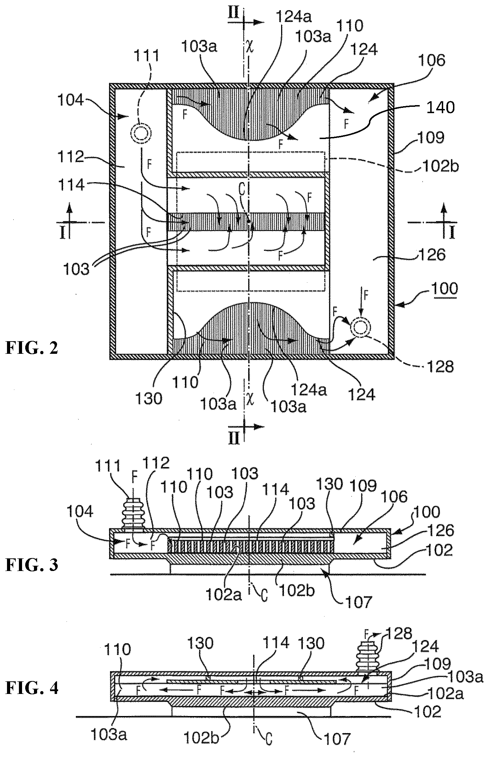

Referring now to FIGS. 2 to 4, an embodiment of a heat exchanger 11 will be described in context of a passive, liquid-cooled cold plate 100 for cooling an electronic component that generates heat while operating. Nevertheless, disclosed principles can be applied to active heat exchangers.

With reference to FIGS. 2 to 4, a fluid heat exchanger (or cold plate) 100 is shown. Fluid heat exchanger 100 includes a heat spreader plate 102, an arrangement of fluid microchannels 103 defined between walls 110, a fluid inlet passage 104, and a fluid outlet passage 106. A housing 109 operates with heat spreader plate 102 to form an outer limit of the heat sink and to define fluid flow passages 104, 106.

As shown in FIGS. 3 and 4, in use the heat exchanger 100 is coupled to a heat source 107, such as an electronic device, including, but not limited to a microchip or an integrated circuit. The heat exchanger may be thermally coupled to the heat source by a thermal interface material disposed therebetween, by coupling directly to the surface of the heat source, or by integrally forming the heat source and at least the heat spreader plate 102 of the fluid heat exchanger. The heat exchanger 100 may take various forms and shapes, but heat spreader plate 102 is formed to accept thermal energy from heat source 107. Heat spreader plate 102 includes an intended heat generating component contact region 102b positioned in a known location thereon. In the illustrated embodiment, heat spreader plate 102 includes a protrusion at region 102b that controls the positioning of the heat spreader plate relative to the heat source, but such a protrusion need not be included. Heat spreader plate 102 may include a portion of more conductive material to facilitate and control heat transfer, if desired. In any event, heat spreader plate is formed to fit over and thermally communicate with a heat source in a region 102b, usually located centrally relative to the edges of the heat spreader plate.

Microchannels 103 are formed to accept and allow passage therethrough of the flow of heat exchanging fluid such that the fluid can move along heat spreader plate 102 and walls 110 and accept and dissipate heat energy from them. In the illustrated embodiment, microchannels 103 are defined by walls 110 that are thermally coupled to the heat spreader plate to accept thermal energy therefrom. For example, heat spreader plate 102 may include an inner facing, upper surface 102a and a plurality of microchannel walls 110 may extend upwardly therefrom, whereby the channel area, defined between upper surface 102a and the microchannel walls 110, channels or directs fluid to create a fluid flow path. The channel area may be open or filled with thermally conductive porous material such as metal or silicon foam, sintered metal, etc. Thermally conductive, porous materials allow flow through the channels but create a tortuous flow path.

Surface 102a and microchannel walls 110 allow the fluid to undergo exchange of thermal energy from the heat spreader plate to cool the heat source coupled to the heat spreader plate. The upper surface 102a and walls 110 have a high thermal conductivity to allow heat transfer from the heat source 107 to fluid passing through channels 103. The surfaces forming channels 103 may be smooth and solid, formed with a porous structure, such as of sintered metal and/or metal or silicon foam or roughened, for example, including troughs and/or crests designed to collect or repel fluid from a particular location or to create selected fluid flow properties. Facing microchannel walls 110 may be configured in a parallel configuration, as shown, or may be formed otherwise, provided fluid can flow between the microchannel walls 110 along a fluid path. It will be apparent to one skilled in the art that the microchannel walls 110 may be alternatively configured in any other appropriate configuration depending on various factors of desired flow, thermal exchange, etc. For instance, grooves may be formed between sections of microchannel walls 110. Generally, microchannel walls 110 may desirably have dimensions and properties which seek to reduce or possibly minimize the pressure drop or differential of fluid flowing through the channels 103 defined therebetween.

The microchannel walls 110 may have a width dimension within the range of 20 microns to 1 millimeter and a height dimension within the range of 100 microns to five millimeters, depending on the power of the heat source 107, desired cooling effect, etc. The microchannel walls 110 may have a length dimension which ranges between 100 microns and several centimeters, depending on the dimensions of, and the heat flux density from, the heat source. In an embodiment, the walls 110 extend the full length (which may be a width) dimension of the heat spreader plate passing fully through region 102b. These are exemplary dimensions and, of course, other microchannel wall dimensions are possible. The microchannel walls 110 may be spaced apart by a separation dimension range, or gap, of 20 microns to 1 millimeter, depending on the power of the heat source 107, desired heat-transfer rates, available pressure head to urge coolant through the microchannels, etc., although other separation (gap)dimensions are also contemplated.

Other microporous channel configurations may be used alternatively to, or together with, microchannels, such as for example, a series of pillars, fins, or undulations, etc. which extend upwards from the heat spreader plate upper surface or tortuous channels as formed by a foam or sintered surface.

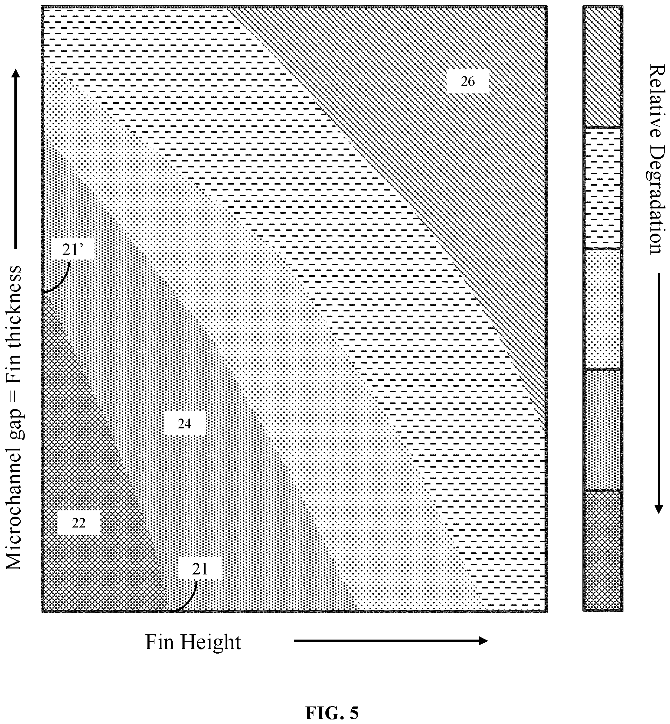

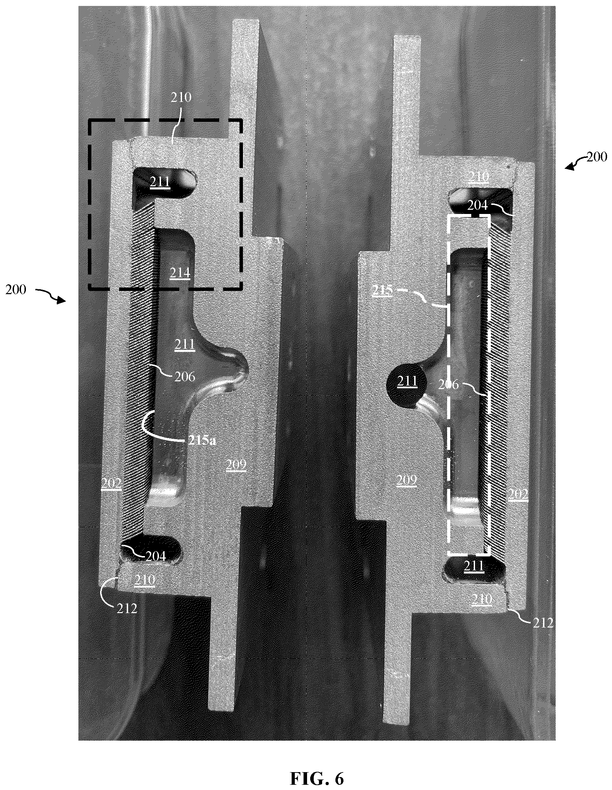

Fluid heat exchanger 100 further includes a fluid inlet passage 104, which in the illustrated embodiment includes a port 111 through the housing opening to a header 112 and thereafter a fluid inlet opening 114 to the microporous fluid channels 103. A seal 130 separates fluid inlet passage 104 from fluid outlet passage 106 so that fluid must pass through the microporous channels 103 past heat spreader plate surface 102a. As well, a plate 140 (analogous to the plate 240 shown in FIGS. 5 and 6 in the '691 patent) may be installed over the walls 110 to close off the channels across the upper limits of walls. The plate has portions removed to create inlet and outlet openings 114 and 124, respectively, in the final heat exchanger. Although the fluid heat exchanger shown in FIGs. 2 to 4 is described as delivering coolant to a central region of the microchannels and exhausting the coolant from opposed end regions of the microchannels, a flow through the heat exchanger 100 can be reversed. Thus, in some embodiments, the inlet passage conveys coolant to the opposed end regions of the microchannels and the outlet passage receives the exhausted coolant from the central region of the microchannels. In still other embodiments, the inlet passage delivers coolant to a plurality of regions positioned between end regions of the microchannels and receives coolant from a plurality of other regions positioned been the end regions of the microchannels.

The '691 patent disclosed a compliant insert that could seal against the fins. However, the compliant insert is incompatible with some cold plates, e.g., cold plates that are assembled using a high-temperature joining process (e.g., a brazing or soldering process). Such high-temperature processes can destroy or damage the compliant insert.

Using conventional wisdom, a person of ordinary skill in the art would avoid any interference between the walls 110 and the plate 140 for cold plates that undergo high-temperature processes (e.g., brazing during cold plate assembly or soldering, e.g., to a CPU, during final system assembly). For example, due to inherent variability during manufacturing, the height of the walls 110 from the heat spreader plate 102 tends to vary. Similarly, a thickness of the plate 140 also will vary, as will the position of any mechanical feature used to locate the plate 140 relative to the walls 110 during final assembly. Thus, conventional techniques for manufacturing and assembling the cold plate would introduce a gap between a distal edge of the walls 110 and an underside of the plate 140, allowing coolant to leak from (or to bypass) the microchannels, introduce a secondary machining operation to reduce variation in height of the walls 110, or both. However, introducing additional machining or other manufacturing steps tends to add cost to the finished cold plate, which in many instances is not economically viable for manufacturers and their customers.

Accordingly, conventional design wisdom tends to favor introducing a small, fin-top gap between the distal (relative to the heat spreader plate 102) edges of the walls (fins) 110 and an underside of the plate 140. Although such a gap allows coolant to leak from the microchannels, degrading performance of the cold plate, such degradation in performance has traditionally been overcome in other areas of the cooling system (e.g., by increasing coolant flow rate through the cold plate, introducing lower-temperature coolant to the cold plate, etc.).

Thus, those of ordinary skill in the art simply incorporate a gap between the fins and the plate to avoid interference and overcome the resulting performance degradation with other system components. But the inventors discovered that, for selected combinations of fin height and microchannel / fin pitch, performance degrades significantly in cold plates with a fin-top gap compared to cold plates without a fin-top gap (e.g., that had undergone secondary machining or other costly processes to reduce dimensional variation among the various cold plate components). For such cold plates, allowing coolant to leak through a fin-top gap tends to degrade performance disproportionately relative to gains in performance that might be available by reducing microchannel / fin pitch to increase surface area available or heat transfer. Further, such performance degradation is not easily overcome by modifications elsewhere in the cooling system.

FIG. 5 shows, schematically, how performance degrades across a selected range of fin height measured from the heat spreader plate 102 and a selected range of microchannel width and fin thickness. "Fin pitch" provides a convenient measure of the number of fins within a selected unit length transverse to a longitudinal axis defined by each fin. Similarly, "microchannel pitch" provides a convenient measure of the number of microchannels within a selected unit length transverse to a longitudinal axis defined by each microchannel. Fin pitch and microchannel pitch also, indirectly, reflect fin thickness and microchannel width, as fins and microchannels tend to become thinner with increasing pitch. Fin thickness and microchannel width are inversely proportional to fin pitch and microchannel pitch, respectively.

FIG. 5 depicts a measure of relative performance of a cold plate having a given fin geometry with a fixed fin-top gap compared to a cold plate having the same fin geometry, but without the fin-top gap. As FIG. 5 suggests, relative degradation in thermal performance for a given fin-top gap increases for higher fin or microchannel pitches and shorter fins.

For instance, the shaded region 22 indicates combinations of fin height (up to a threshold fin height 21) and microchannel / fin width (up to a threshold width 21') that suffer significant degradation in performance compared to an identical cold plate without a fin-top gap. Similarly, the shaded region 24 indicates combinations of fin height and microchannel / fin width that suffer significant, but less, degradation in performance than combinations within the region 22. By contrast, the shaded region 26 indicates combinations of fin height and microchannel / fin width that suffer some, but less significant, degradation in performance.

The schematic relationship in FIG. 5 demonstrates that certain combinations of fin pitch (e.g., assuming fin thickness is the same as microchannel width) and fin length can provide acceptable performance (e.g., acceptably low degradation) even with a fin-top gap, while other combinations of fin pitch and fin length provide unacceptably low performance with a fin-top gap. Thus, conventional approaches that introduce a fin-top gap to handle manufacturing tolerances become unworkable when higher rates of cooling are needed in some systems, e.g., systems that allocate small volumes to cooling system components.

Further, those of ordinary skill in the art have traditionally been deterred from using fins that extend obliquely from the heat spreader plate. For a given fin pitch (e.g., number of fins per centimeter), the resulting gap between adjacent fins, i.e., a microchannel width, is smaller for oblique fins than for fins that extend orthogonally from the heat spreader plate. Those of ordinary skill in the art understand that a smaller microchannel width tends to increase pressure drop through the microchannel compared to a wider microchannel. Thus, in taking steps to minimize pressure loss, an artisan possessing ordinary skill would be deterred from designing a cold plate with oblique fins.

However, the inventors recognized that fins, especially "thin" fins that result from high microchannel/fin pitches, can deform similarly to cantilevered beams when they are subjected to transverse loading. Further, the inventors recognized that such loading can be applied to oblique fins by loading them in a direction transverse to the heat spreader plate 102, e.g., by compressing them with, for example, a plate overtop the fins. Consequently, the inventors discovered that a fin-top gap can be eliminated from a cold plate while still accommodating conventional dimensional tolerances by compressing oblique fins with a plate or other component placed overtop the fins. By contrast, compressing conventional fins that extend orthogonally from the heat-spreader plate to accommodate conventional dimensional tolerances would require an impractically or impossibly high load that is inconsistent with conventional joining techniques, e.g., brazing or soldering. Stated differently, conventional joining techniques for assembling a housing with a heat spreader plate cannot practically and reliably maintain such high compressive loads.

By contrast to conventional cold plates, some disclosed embodiments incorporate short fins (e.g., that meet selected volumetric limitations, e.g., available volume within a server) and relatively high fin pitches (e.g., to pursue theoretically available increases in heat transfer arising from increased fin surface area). For example, some disclosed embodiments incorporate oblique fins that are loaded in compression by a housing overtop the fins, which reduces or eliminates a fin-top gap from the cold plate. Such an embodiment ensures reduces or eliminates leakage from the microchannels, reducing or eliminating performance degradations from a fin-top gap. Further, disclosed concepts can eliminate a separate plate 140 or compliant member, as well as the need for secondary machining of the fins to reduce fin-to-fin and other dimensional variation.

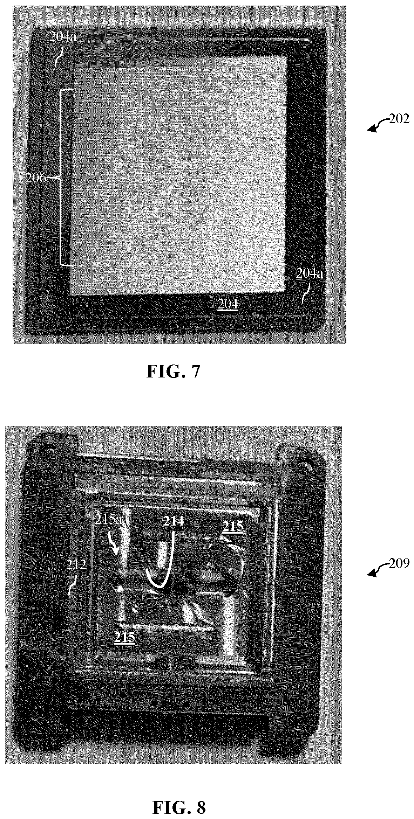

Referring now to FIGS. 6 through 12, a working embodiment of such a liquid-cooled cold plate 200 will be described. In FIG. 6, the cold plate 200 has been sectioned as along line I-I in FIG. 2. Like the cold plate 100, the cold plate 200 has a heat-spreader plate 202 analogous but not identical to heat-spreader plate 102. FIG. 7 shows that, like the heat-spreader plate 102, the heat-spreader plate 202 defines an upper surface 204 from which a plurality of fins 206 extend. Referring again to FIG. 6, the fins 206 extend transversely, but not necessarily perpendicularly, from the upper surface 204 of the heat-spreader plate. For example, the fins 206 extend obliquely from the upper surface 204. As described more fully below, a heat-spreader plate with fins that extend transversely but not perpendicularly from the upper surface 204 of the heat-spreader plate 202 offers certain advantages compared to heat-spreader plates with fins that extend perpendicularly from the upper surface.

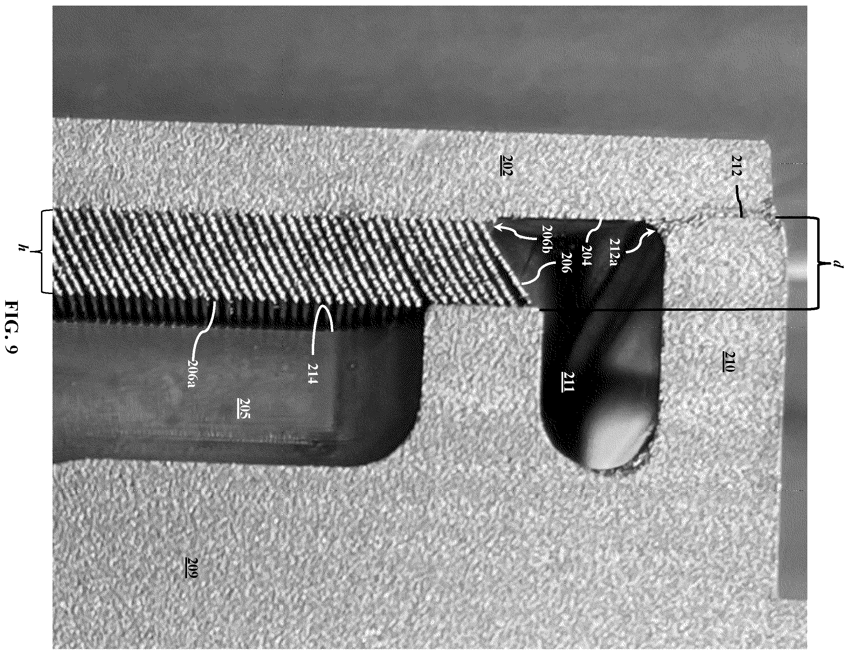

Also similar to the cold plate 100, which has a housing 109 that overlies the heat-spreader plate 102, the cold plate 200 also has a housing 209 that overlies the heat-spreader plate 202. And, like the heat-spreader 102, the heat-spreader 202 has an upper surface 204 from which a plurality of fins 206 (analogous to walls 110) extend. Further, similar to the housing 109 of the cold plate 100, the housing 209 of the cold plate 200 has side walls 210 that extend downwardly and cooperate with the heat-spreader plate 202 to enclose an interior volume 211 of the cold plate 200. More particularly, in the embodiment shown in FIG. 6, the downwardly extending side walls 210 define a lower-most (e.g., proximal) face 212 that abuts the upper surface 204 of the heat-spreader plate 202. In FIG. 6, the lower-most face 212 of the housing 202 is brazed with a peripheral region 204a (also see FIG. 7) of the upper surface 204. The brazed joint 212a is visible in FIG. 6 and in the enlarged view shown in FIG. 9.

However, the cold plate 200 is different from the cold plate 100 shown in FIGS. 2 to 4 in several respects. For example, the cold plate 200 omits the un-numbered plate and seal 130 shown among FIGS. 2 to 4. Instead, the housing 209 of the cold plate 200 incorporates features defining a continuous inlet passage 205 (a portion of the enclosed interior volume 211) for directing coolant from an inlet (not shown) to an opening 214 analogous to the fluid inlet opening 114. Also, the side walls 210 of the housing 209 (also shown in FIG. 8) extend downwardly to and abut the upper surface 204 of the heat-spreader plate 202 (also shown in FIG. 7), rather than overlapping with the heat-spreader plate 202 as the housing 109 overlaps the heat spreader plate 102. The overlapping arrangement of the housing 109 relative to the heat-spreader plate 102 is shown in the cross-sectional views of FIGS. 3 and 4.

Further, the housing 209 of the cold plate 200 urges against the fins 206 (analogous to walls 110) sufficiently to inhibit or prevent coolant from bypassing the channels between the fins 206, or from leaking from one channel to another over top the fins. More particularly, as FIGS. 6 and 8 show, the housing 209 defines a boss 215 (enclosed by dashed outline in FIG. 6) extending proximally toward the fins 206 (relative to the heat-spreader plate 202). The boss 215 defines a substantially planar major surface 215a that contacts the distal ends 206a (FIG. 9) of the fins 206. Moreover, the substantially planar major surface 215a defines an aperture 214, which is analogous to the opening 114 defined by the unnumbered plate in FIGS. 2 to 4. As shown particularly well in FIG. 6, the aperture 214 permits incoming coolant from the inlet passage 205 to enter the microchannels between the fins 206.

In some embodiments, the planar major surface 215a of the boss 215 urges against distal edges 206a (FIG. 9) of the fins 206 with sufficient force to deflect the fins 206 from an unloaded, at-rest orientation, ensuring sufficient interference between the fins and the planar surface 215a of the boss 215 to prevent (or at least substantially inhibit) coolant from bypassing the microchannels or from leaking from one microchannel to an adjacent microchannel (e.g., overtop a distal edge 206a of a fin 206 positioned between the microchannel and the adjacent microchannel). The surface 215a of the boss 215 in contact with the distal fin ends 206a performs an analogous function to the function that the unnumbered plate of the cold plate 100 (shown among FIGS. 2 to 4) performs.

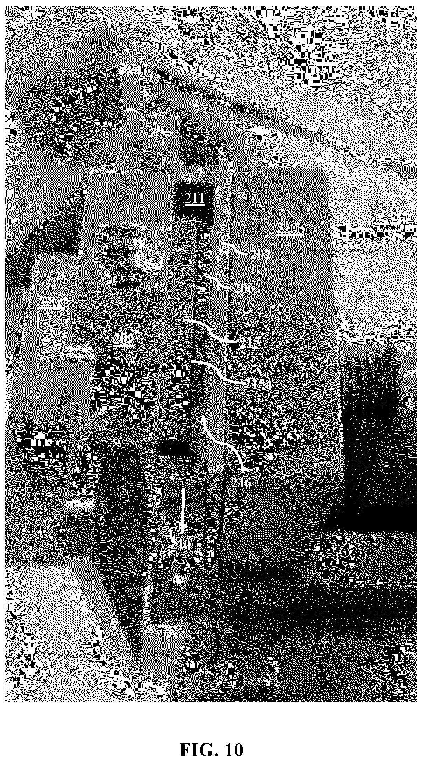

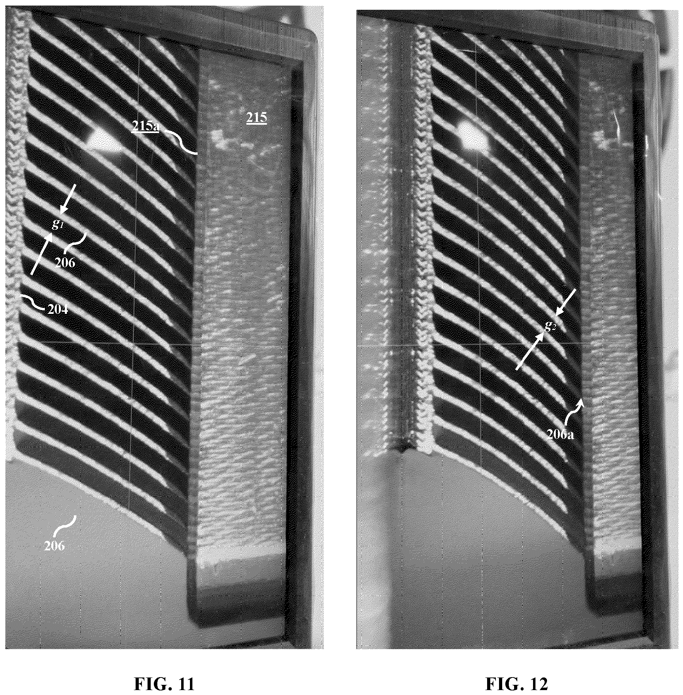

FIG. 10 shows the housing 209 and the heat-spreader plate 202 positioned in a jig 220a, 220b, with one of the side walls 210 of the housing removed to reveal internal features of the cold plate 200, including the interior volume 211, the boss 215 and the lower major surface 215a of the boss in contact with the fins 206. In FIG. 10, the lower surface 215a of the boss 215 is in contact with the distal edges 206a of the fins 206. However, a small gap 216 remains between the lower face 212 of the side walls 210 and the upper surface 204 of the heat-spreader plate 202. As the jaws of the jig 220a, 220b further compress the housing 209 and the heat-spreader plate 202 together, the fins 206 can resiliently deflect, closing the gap 216 and allowing the lower face 212 of the side walls 210 to contact the upper surface 204 of the heat-spreader plate 202. FIGS. 11 and 12 show close-up images of the fins 206 in contact with the surface 215a of the boss 215. In FIG. 11, the gap 216 (FIG. 10) remains between the lower face 212 of the side walls 210 and the upper surface 204 of the heat-spreader plate 202. In FIG. 12, the gap 216 has somewhat closed and the lower face 212 of the side walls 210 contacts the upper surface 204 of the heat-spreader plate 202. A comparison of FIGS. 11 and 12 demonstrates that the distal ends 206a of the fins 206 have deflected farther in FIG. 12 than in FIG. 11, which has allowed the gap 216 to close. Once in contact with each other, the lower face 212 of the side walls 210 and the upper surface 204 of the heat-spreader plate 202 can be joined together, e.g., brazed, soldered, welded, bonded or otherwise joined, together to form a joint 212a as shown by way of example in FIGS. 6 and 9.

In some embodiments, including the working embodiment depicted in FIG. 6, the fins 206 are so fabricated (e.g., skived) that their unloaded, at-rest orientation is oblique (e.g., transverse, but not perpendicular) to an upper surface 204 of the heat-spreader plate 202. As used herein, the phrase "unloaded, at-rest orientation" refers to an orientation of the fins relative to an upper surface 204 (or other reference surface) of the heat-spreader plate 202 before the housing 209 contacts the fins. By fabricating fins that are oblique to the upper surface 204 (or other reference surface) of the heat-spreader plate 202, a compressive load applied to the distal fin ends 206a by the lower surface 215a of the housing's boss 215 can cause the fins to deflect in a predictable and repeatable manner.

Such deflection can accommodate dimensional variations (e.g., dimensional tolerances) that accumulate among various features of the heat-spreader plate 202, fins 206 and housing 209. For example, through ordinary manufacturing variations, a height, h, (FIG. 9) of the fins 206 above the upper surface 204 (or other reference surface) of the heat-spreader plate can vary from one heat-spreader plate to the next or from one batch of heat-spreader plates to the next. Still further, through ordinary manufacturing variations, an inter-planar distance, d, (FIG. 9) between the lower face 212 of the side walls 210 and the lower face 215a of the boss 215 can vary from one housing to the next or from one batch of housings to the next. Such heights and inter-planar spacings can also vary between or among manufacturing sites, e.g., due to the age of the tool used to fabricate the heat-spreader plate or housing, inherent variations in material properties among different ingots or starting blanks of the heat-spreader plate or housing, etc.

Moreover, accommodating such dimensional variations by fin deflection can ensure the fins 206 contact the lower surface 215a of the housing to inhibit or eliminate coolant leakage from one microchannel to another microchannel. Ensuring contact between the fins and the housing eliminates the need for a separate component, e.g., the un-numbered plate in FIGS. 2 to 4, the seal 130 in FIGS. 2 to 4, or both, to inhibit or eliminate coolant leakage from one microchannel to another microchannel. Further, by accommodating such dimensional variations through fin deflection, e.g., by permitting the fins to interfere with the housing, contact between the fins and the housing can be ensured without requiring a separate joining technique to be applied between the fins and the housing. By eliminating such a joining technique between the fins and the housing, the channels can remain clear and unclogged, in contrast to the partially or wholly clogged microchannels that typically arise from brazing, soldering, or bonding (as through adhesives) or other joining technique applied between the fins and the housing. For example, flux used in a soldering or a brazing technique, or even the solder or brazing material, can flow into the microchannels during soldering or brazing of the fins and housing. Once such material is in the microchannels, it can be difficult or impossible to remove, reducing fin area available for heat-transfer and thereby harming overall cooling capability of the cold plate. Adhesive bonding and other joining techniques suffer similar deficiencies that are overcome using interference sealing between the fins and the housing as described herein.

By selecting suitable combinations of nominal fin heights, h, nominal inter-planar spacings, d, allowable dimensional tolerances on these dimensions, as well as nominal and maximum-desired fin deflections (e.g., as depicted in the comparison of FIGS. 11 and 12), the cold plate 200 can be manufactured in relatively high volumes using efficient joining techniques and without the need for secondary machining, while maintaining consistent, high-performance heat transfer between the intended heat-receiving region of the heat-spreader plate 202 and the coolant flowing through the cold plate 200.

Each fin 206 can be considered as a cantilevered beam with a proximal end 206b of the fin being continuous with and supported by the upper surface 204 of the heat-spreader plate 202. Each fin 206 also has a distal end 206a positioned distally away from the heat-spreader plate 204. The lower surface 215a of the housing 209 contacts the distal fin ends 206a or a region adjacent thereto when the cold plate 200 is assembled together as shown in FIG. 6. A force applied to the distal fin ends 206a by the lower surface 215a of the housing 209 can be approximated as a point load applied to a cantilevered beam extending from the heat-spreader plate 204. Deflection of each fin can loosely be approximated by beam equations, and a "point" load applied to the modeled beam can be approximated by decomposing the compressive load applied by the housing 209 to the fins 206 into a component that is applied perpendicularly to the distal fin end and a component that is applied longitudinally to the distal fin end. As the fins 206 deflect from their at-rest, unloaded orientation under, e.g., increasing compressive loading, a ratio between the longitudinal and perpendicular components can change, as well as the magnitude of each component.

As noted, a lateral deflection (e.g., in a direction parallel to the upper surface 204 of the heat-spreader plate 202 for a planar or substantially planar upper surface of the heat-spreader plate 202) of each fin 206 under compression loading by the housing 209 can be approximated using equations describing deflection of a cantilevered beam with a perpendicular point load applied to its distal end. Such an approximation may not be entirely accurate as deflection of the distal ends 206a of the fins increase because the perpendicular component of the load applied to the distal regions of the fins will change (e.g., increase) as the distal edges of the fins move relative to (e.g., slide along) the lower surface 215a of the housing's boss 215. Generally speaking, the beam equations become relatively less accurate as deflections increase, as assumptions of linearity break down and non-linear behaviors become dominant as deflections increase.

In the unloaded, at-rest orientation, each fin 206 among a selected plurality of fins is generally parallel with the other fins among the selected plurality of fins. Moreover, except for any taper within each fin distally of the heat-spreader base 202, a gap, *g₁,* (FIG. 11), e.g., measured between adjacent fins 206, orthogonally to the fins 206, is substantially constant in the unloaded, at-rest orientation. However, when the fins 206 are loaded and deformed as in FIGS. 6, 9 and 12, the gap, *g₂*, between fins 206 (measured generally orthogonally to the fins) tends to decrease with increasing distance away from the upper surface 204 of the heat-spreader base 202, e.g., may decrease with increasing distal position. The gap, *g₂,* tapers between adjacent fins 206 because the cantilevered fins deform while the bases of the fins remain substantially fixed to the heat spreader base 202.

A comparison of the images in FIGS. 11 and 12 shows such a tapered horizontal gap. In FIG. 11, the fins 206 are under less of a compressive load by the housing's boss 215 than the fins are in FIG. 12. As shown, the distal end 206a of each fin in FIG. 12 is closer to an adjacent fin than in FIG. 11.

Regardless of whether deflection of the fins occurs elastically or plastically, the deflection of the fins can be conceptualized, generally, as deflections of cantilevered beams with point loads applied to the distal ends until the distal ends of the fins come into contact with adjacent fin walls. Nevertheless, those of ordinary skill in the art will understand and appreciate that classical beam equations, whether based on small deflection assumptions or large deflection assumptions, do not adequately predict the load-based deflections observed by compressing fins as described herein. Rather, such loading leads to non-linear behaviors. Beyond that threshold of fin deflection, the fins may continue to deflect, e.g., as cantilevered beams under a plurality of point loads and/or one or more distributed loads. Nevertheless, such large fin deflections may be less desirable than more modest fin deflections to limit or avoid a material change in effective channel cross-sectional area available to convey coolant over the fins to facilitate convective heat-transfer with the fins. For example, a reduction in effective channel cross-sectional area (e.g., from a diminishing gap, g, between adjacent fins) would tend to choke a flow of coolant over the fins, e.g., particularly the distal ends of the fins, and thus reduce a rate of convective heat-transfer beyond that anticipated by fin efficiency alone. Accordingly, a suitable combination of at-rest fin orientation (e.g., angle measured from perpendicular), fin height, h, inter-planar spacing, d, between the surface 215a of the boss 215 and the lower face 212 of the side walls 210, and dimensional tolerances around each of these dimensions, as well as a selected upper-threshold of fin deflection from the at-rest fin orientation, can be selected to achieve desired thermal performance, manufacturing speed or efficiency and other measures of goodness for manufactured cold plates 200.

For example, the plurality of fins can be so fabricated that the at-rest orientation of the fins 206 is about 30-degrees from perpendicular (relative to the upper surface 204 of the heat-spreader plate 202). In general, suitable at-rest orientations allow the fins to deflect in the direction they are angled when the housing 209 contacts them during assembly. Also, generally speaking and as described above, the fins deflect until the upper surface 204 of the heat-spreader plate 202 (or other reference surface of the heat-spreader plate) touches the lower face 212 of the side walls 210 (or other reference surface of the housing). According to some heat-spreader designs, an upper threshold angle of the deflected fins from perpendicular (relative to an upper or other reference surface of the heat-spreader plate) is about 45-degrees, e.g., between about 30-degrees (or other selected at-rest orientation) and about 55-degrees, such as, for example, between about 40-degrees and about 50-degrees. In a particular embodiment, the fins 206 in a finally assembled cold plate should be angled between about 30-degrees and about 44.3-degrees, after considering the dimensions and dimensional tolerances described above.

Although the specific dimensions and dimensional tolerances described in this example pertain to heat-spreader plates and housings produced from an alloy of copper and a brazed joint between the housing and the heat-spreader plate, the principles discussed herein can be applied to different materials and different joining processes suitable for a selected material or material combination. For example, these principles can be applied to joints formed using, for example, ultrasonic welding, laser welding, soldering, adhesive bonding and other joining techniques now known or hereafter developed. Further, heat-spreaders and housings can be produced from any of a variety of materials or combinations of different materials. For example, either or both the heat-spreader 202 and housing 209 can be produced from one or more materials, such as, for example, aluminum, copper, steel, plastic, or combinations thereof. Moreover, disclosed heat-spreaders can be formed from a different alloy or an altogether different material than that used to fabricate a housing that is to be assembled with such heat-spreader into a cold plate as described herein. Similarly, techniques such as, for example, skiving or brazing or soldering or welding or bonding, described herein are used by way of example and not limitation.

In the unloaded, at-rest orientation, the fins can be oriented up to about 70-degrees from perpendicular (relative to the upper surface 204 of the heat-spreader plate), which corresponds to a lower threshold angle-of-departure of about 20-degrees from the upper surface of the heat-spreader plate. This upper-threshold orientation angle from perpendicular corresponds to lower-threshold approach angle achievable by a skiving machine. Naturally, other fin-manufacturing techniques are possible so the upper threshold orientation angle (or lower threshold angle-of-departure) can vary from these values according to the manufacturing technique chosen. Lower threshold values of fin orientation, e.g., approaching zero-degrees from perpendicular, or upper threshold values of angle-of-departure from the upper surface 204 that approach 90-degrees are possible and predominantly are based on available compressive loading between the housing 209 and the fins 206 and a design condition that avoids buckling (e.g., Euler buckling) of the fins in compression.

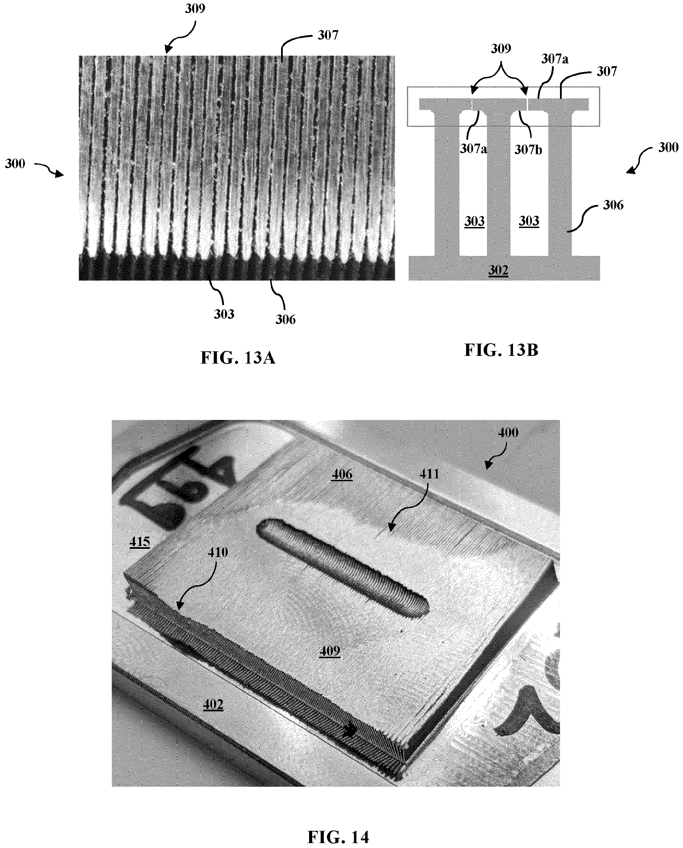

FIGs. 13A to 16 show other aspects of disclosed cold plates. Referring now to FIGs. 13A and 13B, a cold plate 300 having flared fins is described. Like the cold plate 200, the cold plate 300 has a heat-spreader plate 302 analogous but not identical to heat-spreader plate 102. FIGs. 13B and 14 show that, like the heat-spreader plates 102, 202, the heat-spreader plate 302 defines an upper surface from which a plurality of fins 306 extend. The fins 306 extend transversely, but not necessarily perpendicularly, from the upper surface of the heat-spreader plate 302. For example, the fins 306 can extend obliquely from the upper surface.

Also similar to the cold plates 100, 200, a housing can overlie the heat-spreader plate 302. Such a housing can have side walls that extend downwardly and cooperate with the heat-spreader plate 302 to enclose an interior volume 315 (FIG. 14) of the cold plate 300. Like the embodiment shown in FIG. 6, such downwardly extending side walls can define a lower-most (e.g., proximal) face that abuts the upper surface of the heat-spreader plate 302, or the downwardly extending side walls can overlap an outer periphery of the heat-spreader plate 302. As with embodiments described above, the housing can be brazed or otherwise fused with a peripheral region of the cold plate 302.

However, the cold plate 300 is different from the cold plate 100 in some respects. For example, the cold plate 300 can omit the un-numbered plate and seal 130 shown among FIGS. 2 to 4, like the cold plate 200. As FIG. 13B shows, the fins 306 can be spaced apart from each other to define a microchannel 303 between adjacent fins. The distal edges 307 of the fins 306 can flare laterally outward, as shown schematically in FIG. 13B, defining opposed lateral flanges 307a, 307b that give the distal edges of the fins a "mushroom-shaped" appearance in cross-section. As shown in FIG. 13B, the flanges 307a, 307b that extend laterally outward from one fin also extend laterally toward a distal edge of an adjacent fin, wholly or partially closing off a distal region of the microchannel 303 therebetween. As FIG. 13B shows, a gap 309 (e.g., narrower than the width of a microchannel 303) can span between a flange 307a of one fin 306 and an adjacent flange 307b of the adjacent fin 306. In some embodiments, the gap 309 can extend along an entire length of the microchannel 303 or along just a segment of the microchannel. In other embodiments, the gap 309 does not exist because the flange of one fin abuts or overlaps with the adjacent flange of an adjacent fin.

Such a flared distal edge 307 provides an enlarged distal contact surface compared to raw distal edges that result when the fins are formed, e.g., with a skiving technique, further enhancing contact with a housing when assembled using a technique as described above in connection with the cold plate 200. Alternatively (or additionally), such enlarged distal edges 307 can be joined or fused with another member, e.g., a housing, even when such joining techniques involve a flux or other joining additive that ordinarily might wick into small gaps, e.g., microchannels. Such fins 306 are amenable to being brazed or otherwise fused (e.g., fusion welded or friction stir welded) together with a housing.

FIG. 14 shows an intermediate construct during manufacture of a working embodiment of such a cold plate. As with the cold plates described above, the cold plate 400 shown in FIG. 14 has a plurality of spaced-apart fins 406 that microchannels positioned therebetween adjacent fins. A first region 409 of the fins define flared distal edges, as described above in connection with FIGs. 13A and 13B. The fins in a second region 406 have raw distal edges that resulted when the fins were formed using a skiving process, e.g., without any secondary machining or other secondary operation. The first region 409 and the second region 406 are distinguishable from each other by the boundary 411, e.g., the boundary between regions having different sheen in FIG. 14. Like the cold plates described above, the cold plate 400 has an interior region 415 that can be enclosed by a housing, as well as an upper surface 402 that can be joined with such a housing.

Ductile copper alloys can be well-suited for such cold plates and flared fins. For example, grinding or milling the raw distal fin edges that result from skiving or otherwise forming the fins can tend to "smear" the fin material near the distal edges, defining the flanges 307a, 307b described above. In some instances, the distal fin material can "smear" longitudinally of the fins, as with the region 410 shown in FIG. 14, providing additional surface area suitable for joining the fins with a housing.

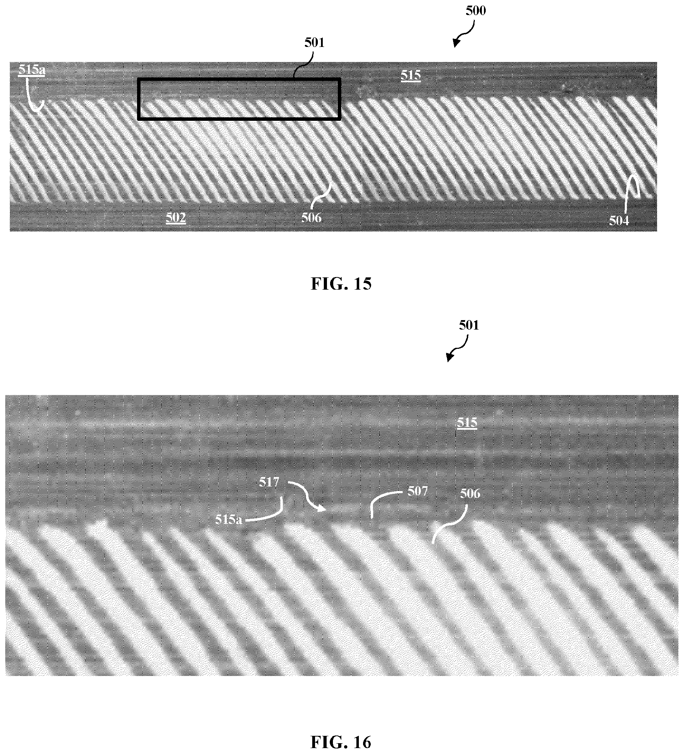

FIGs. 15 and 16 depict such a joint from a cross-sectioned working embodiment 500. In FIG. 15, a plurality of spaced-apart fins 506 extend transversely from the upper surface 504 of a heat-spreader plate 502. The flared distal edges 507 (FIG. 16) of the fins 506 are fused with an underside surface 515a of a housing 515. For example, the flared distal edges 507 are soldered with the underside surface 515a, though other fusing techniques can be used, as well, including by way of example and without limitation brazing or welding (to include without limitation friction stir welding or other welding process). The enlargement of region 501 shown in FIG. 16 shows a bond-line 517 resulting from the soldering process used to join the distal edges 507 of the fins 506 with the underside 515a of the housing 515. Notably absent from the microchannels between the fins 506 is any flux or solder or other joining material, as the flared distal edges of the fins block the flux or solder or other joining material from wicking or otherwise seeping into the microchannels. Thus, a cold plate having flared distal edges can be suited for omitting the plate and seal or other intermediate component from between the housing and the fins.

Fin heights, h, can range from about 1 mm to about 10 mm, such as from about 0.9mm to about 12 mm, for example between about 1.1 mm to about 8 mm. Considerations of heat-transfer performance, manufacturability and practically available compressive load between the housing and the fins can drive a practical lower-threshold fin height. Considerations of cold plate density, fin efficiency (e.g., diminishing returns on thermal performance for taller fins) and pressure drop considerations can drive a practical upper-threshold fin height. Fin thickness can range from about 0.05 mm to about 1 mm, such as, for example, from about 0.05 mm to about 0.8 mm. Considerations of manufacturability, thermal performance, and deformation under normal operation can drive selection of lower-threshold fin thickness and considerations of manufacturability, assembly force and thermal performance can drive selection of upper-threshold fin thickness. Microchannel length (e.g., spanwise fin length) can range from about 5 mm to about 300 mm, with considerations of manufacturability, length of skiving blade, force required to compress / deflect the fins and head loss through the microchannels can drive selection of practical upper-threshold microchannel lengths, while considerations of thermal performance can drive selection of practical lower-threshold microchannel lengths. Microchannel widths, e.g., nominal dimensions of the gap, g, between fins, can range from about 0.1. mm to about 1 mm. Considerations of fouling, filter requirements, viscosity, erosion and corrosion can drive selection of practical lower-threshold gap dimension while considerations of thermal performance and head loss can drive practical selections of upper-threshold gap dimensions. Although any number of fins defined by a heat-spreader plate can be possible, a practical limit to the number of fins on a given heat-spreader plate can be derived from available compressive loading during assembly of the housing and the heat-spreader plate, with increasing numbers of fins requiring incrementally higher compressive forces. Embodiments of cold plates with large numbers of fins, e.g., that would require excessive compressive forces, can be brazed or otherwise fused or joined with a housing, in part by incorporating flared distal fin edges.

### OTHER EXEMPLARY EMBODIMENTS

The embodiments described above generally concern fluidic and heat transfer devices, assemblies and systems configured to cool one or more electronic components, such as, for example, integrated circuits. Nonetheless, other heat-transfer applications for disclosed heat exchangers and cold plates are contemplated, together with any attendant changes in configuration of the disclosed apparatus. Incorporating the principles disclosed herein, it is possible to provide a wide variety of systems configured to transfer heat using a fluid circuit. For example, disclosed systems and components, including heat exchangers described by way of reference to cold plate 200 can be used to transfer heat to or from components in a data center, laser components, light-emitting diodes, chemical reactions, photovoltaic cells, solar collectors, and a variety of other industrial, military and consumer devices now known and hereafter developed.

Further, directions and references (*e.g.,* up, down, top, bottom, left, right, rearward, forward, etc.) may be used to facilitate discussion of the drawings but are not intended to be limiting. For example, certain terms may be used such as "up," "down,", "upper," "lower," "horizontal," "vertical," "left," "right," and the like. Such terms are used, where applicable, to provide some clarity of description when dealing with relative relationships, particularly with respect to the illustrated embodiments. Such terms are not, however, intended to imply absolute relationships, positions, and/or orientations. For example, with respect to an object, an "upper" surface can become a "lower" surface simply by turning the object over. Nevertheless, it is still the same surface and the object remains the same. As used herein, "and/or" means "and" or "or", as well as "and" and "or." Moreover, all patent and non-patent literature cited herein is hereby incorporated by references in its entirety for all purposes.

The principles described above in connection with any particular embodiment can be combined with the principles described in connection with any one or more of the other embodiments. Accordingly, this detailed description shall not be construed in a limiting sense, and following a review of this disclosure, those of ordinary skill in the art will appreciate the wide variety of heat exchanger and cooling system embodiments that can be devised using the various concepts described herein. Moreover, those of ordinary skill in the art will appreciate that the exemplary embodiments disclosed herein can be adapted to various configurations without departing from the disclosed principles.

Thus, this disclosure and the claims appended hereto are not intended to be limited to the embodiments shown herein, but instead is to be accorded the full scope consistent with the language of the description and principles described, wherein reference to an element in the singular, such as by use of the article "a" or "an" is not intended to mean "one and only one" unless specifically so stated, but rather "one or more."

Further, in view of the many possible embodiments to which the disclosed principles can be applied, we reserve the right to claim all that comes within the scope and spirit of the foregoing description, including any and all combinations of features and technologies described herein, literally and equivalently, as understood by a person of ordinary skill in the art, regardless of whether such combinations may be recited in the claims appended hereto or throughout prosecution of this application or any application claiming benefit of or priority from this application. All structural and functional equivalents to the elements of the various embodiments described throughout the disclosure that are known or later come to be known to those of ordinary skill in the art are intended to be encompassed by the elements of the claims. Moreover, nothing disclosed herein is intended to be dedicated to the public regardless of whether such disclosure is explicitly recited in the claims. No feature claimed in this or any other patent application claiming priority from or benefit of this application is to be construed under the provisions of 35 USC 112, sixth paragraph, unless the feature is expressly recited using the phrase "means for" or "step for".

Thus, in view of the many possible embodiments to which the disclosed principles can be applied, it should be recognized that the above-described embodiments are only examples and should not be taken as limiting in scope. We therefore reserve all rights to the subject matter disclosed herein.

## Claims

1. A heat exchanger configured to convey energy in the form of heat from a heat-generating component to a coolant, the heat exchanger comprising:
a heat spreader plate defining an upper surface and a plurality of fins extending transversely from the upper surface to respective distal fin edges, wherein the plurality of fins define a corresponding plurality of microchannels between adjacent ones of the plurality of fins;
a housing defining an underside surface positioned overtop the distal fin edges, wherein the underside surface urges against the distal fin edges sufficiently to substantially inhibit a coolant from leaking from one microchannel to an adjacent microchannel.

2. The heat exchanger of claim 1, further comprising an inlet passage and an outlet passage, wherein the heat exchanger is configured to convey the coolant from the inlet passage to the plurality of microchannels and from the plurality of microchannels to the outlet passage.

3. The heat exchanger of claim 1, wherein the housing and the heat spreader plate are joined together with a high-temperature process.

4. The heat exchanger of claim 1, wherein each in the plurality of fins extends obliquely from the upper surface of the heat spreader plate.

5. The heat exchanger of claim 1, wherein the underside surface urges against the distal fin edges sufficiently to deflect the fins from an unloaded, at-rest orientation.

6. The heat exchanger of claim 1, wherein the underside surface is fused with the distal fin edges.

7. The heat exchanger of claim 1, wherein the distal fin edges comprise flared distal fin edges.

8. The heat exchanger of claim 7: wherein the underside surface is fused with the flared distal fin edges; or wherein the underside surface is brazed with the flared distal fin edges.

9. A heat exchanger configured to convey energy in the form of heat from a heat-generating component to a coolant, the heat exchanger comprising:
a heat spreader plate defining an upper surface and a plurality of fins extending transversely from the upper surface to respective distal fin edges, wherein the plurality of fins define a corresponding plurality of microchannels between adjacent ones of the plurality of fins, wherein the distal fin edges are laterally flared to at least partially enclose a distal region of each microchannel;
a housing defining an underside surface positioned overtop the flared distal fin edges, wherein the underside surface and the distal fin edges are sufficiently joined together to substantially inhibit a coolant from leaking from one microchannel to an adjacent microchannel.

10. The heat exchanger of claim 9, further comprising an inlet passage and an outlet passage, wherein the heat exchanger is configured to convey the coolant from the inlet passage to the plurality of microchannels and from the plurality of microchannels to the outlet passage.

11. The heat exchanger of claim 9: wherein the housing and the heat spreader plate are joined together using a high-temperature process; or wherein each in the plurality of fins extends obliquely from the upper surface of the heat spreader plate; or wherein the underside surface urges against the flared distal fin edges sufficiently to deflect the fins from an unloaded, at-rest orientation.

12. The heat exchanger of claim 9, wherein the underside surface is fused with the flared distal fin edges, and, optionally, wherein the underside surface is brazed with the flared distal fin edges, and, further optionally, wherein the microchannels are substantially free of any flux or solder or other brazing material.

13. An electronic device, comprising:
a heat-generating electronic component; and
a cold plate having a heat spreader plate positioned in thermal contact with the heat-generating component and a housing enclosing an interior region of the cold plate, wherein the heat spreader plate defines an upper surface and a plurality of fins extending transversely from the upper surface to respective distal fin edges, wherein the plurality of fins define a corresponding plurality of microchannels between adjacent ones of the plurality of fins, the cold plate further having a housing defining an underside surface positioned overtop the distal fin edges, wherein the underside surface and the distal fin edges urge together and substantially inhibit a coolant from leaking from one microchannel to an adjacent microchannel, wherein the housing and the heat spreader plate are fused together.

14. The electronic device according to claim 13, wherein the distal fin edges are laterally flared and wherein the underside of the housing and the flared distal fin edges are brazed together, wherein the microchannels are substantially free of any brazing material.

15. The electronic device according to claim 13, wherein the distal fin edges urge in compression between the underside of the housing and the upper surface of the heat spreader plate sufficiently to deflect the plurality of fins from an unloaded, at-rest orientation.
